Europäisches Patentamt

European Patent Office

Office européen des brevets

(19)

(11) **EP 1 418 438 A2**

(12) **EUROPÄISCHE PATENTANMELDUNG**

(43) Veröffentlichungstag:
**12.05.2004 Patentblatt 2004/20**

(51) Int Cl.7: **G01R 31/28**

(21) Anmeldenummer: 03025291.0

(22) Anmeldetag: **06.11.2003**

(84) Benannte Vertragsstaaten:
**AT BE BG CH CY CZ DE DK EE ES FI FR GB GR HU IE IT LI LU MC NL PT RO SE SI SK TR**
Benannte Erstreckungsstaaten:
**AL LT LV MK**

(30) Priorität: **08.11.2002 DE 10252561**

(71) Anmelder: **Ralf Spillecke**
**47249 Duisburg (DE)**

(72) Erfinder: **Ralf Spillecke**
**47249 Duisburg (DE)**

(74) Vertreter: **Viering, Jentschura & Partner**
**Centroallee 263**
**46047 Oberhausen (DE)**

(54) **Klimaprüfkammer**

(57) Die Erfindung betrifft eine Vorrichtung und ein Verfahren zum Betauen eines Prüflings. Um eine verbesserte Reproduzierbarkeit der Betauung zu erreichen, weist die Vorrichtung einen Prüfbehälter (11), welcher einen hermetisch nach außen hin abdichtbaren Prüfraum (12) zur Aufnahme eines Prüflings ausbildet, und eine Betauungseinrichtung zum Betauen des Prüflings innerhalb des Prüfraums (12) auf, wobei die Betauungseinrichtung eine Kühlvorrichtung zum Abkühlen des Prüflings auf einen Temperaturwert, bei dem eine Betauung des Prüflings erfolgt, aufweist, und wobei Mittel zum Zuführen eines Versorgungsklimas mit gegenüber dem Prüfraum erhöhter Luftfeuchtigkeit oder Temperatur in den Prüfraum vorgesehen sind.

Fig. 1

**Beschreibung**

Die Erfindung betrifft eine Vorrichtung und ein Verfahren zum Betauen eines Prüflings, insbesondere elektronischer Bauteile oder dergleichen.

Derartige Betauungsvorrichtungen und -verfahren werden eingesetzt, um etwaige Veränderungen wichtiger Eigenschaften eines Prüflings (z.B. Veränderungen der elektronischen Eigenschaften einer elektronischen Leiterplatte, etwa elektronischer Baugruppen eines Kraftfahrzeugs) bei Taupunktunterschreitung untersuchen zu können. Auf einer solchen elektronischen Leiterplatte kann ein sich auf der Oberfläche der Leiterplatte ausbildender Betauungsfilm beispielsweise zu elektrochemischen Migrationseffekten und damit zu einer Funktionsstörung der elektronischen Baugruppe oder sogar einem vollständigen Ausfall der Leiterplatte führen. Im Falle des Nachweises von Funktionsstörungen bei Taupunktunterschreitung sind geeignete Maßnahmen zum Schutz der Baugruppe vor Betauungseinflüssen (z.B. in Form einer Schutzlackierung) zu treffen.

Die Erfindung ist ganz allgemein für jede Meßanwendung einsetzbar, bei der die kontrollierte Erzeugung eines Betauungsfilms auf einem Prüfling von Bedeutung ist.

Gemäß einem bekannten Verfahren zur Betauung wird eine elektronische Baugruppe in trockenem Zustand in einem Klimaschrank mit sogenannter Betauungsoption plaziert. Daraufhin wird die Temperatur innerhalb des Klimaschranks in festen Temperaturschritten von beispielsweise 10°C erhöht, woraufhin sich infolge der Temperaturdifferenz zwischen der elektronischen Baugruppe und ihrer Umgebung im Klimaschrank ein Betauungsfilm auf der Oberfläche der Baugruppe ausbildet. Das Entstehen des Betauungsfilms wird beispielsweise visuell beobachtet und die elektrische Funktion wird von einem rechnergestützten Prüfstand überwacht.

Das bekannte Verfahren bzw. die dabei verwendete Vorrichtung haben jedoch den Nachteil, daß sowohl die schrittweise Temperaturerhöhung als auch der Nachweis der Betauung am Prüfling Meßfehlern unterworfen sind, so daß die für Durchführung zuverlässiger Testreihen mit mehreren Meßzyklen notwendige Reproduzierbarkeit beeinträchtigt wird. Eine Kompensation der Meßfehler ist wegen der Mehrzahl von fehlerbehafteten Parametern (Temperatur, Betauung) schwierig und aufwendig. Infolgedessen ist gegebenenfalls auch die Entscheidung hinsichtlich der zu treffenden Schutzmaßnahmen fehlerbehaftet und die Realisierung beispielsweise elektronischer Baugruppen in Kraftfahrzeugen, die auch unter Betauungseinflüssen störungsfrei arbeiten, wird erschwert.

Aufgabe der vorliegenden Erfindung ist es daher, eine Vorrichtung und ein Verfahren zur Betauung zu schaffen, wobei eine verbesserte Reproduzierbarkeit der Betauungsbedingungen erreicht wird.

Diese Aufgabe wird gemäß den Merkmalen der unabhängigen Patentansprüche gelöst.

Die erfindungsgemäße Vorrichtung zum Betauen eines Prüflings weist einen Prüfbehälter, welcher einen hermetisch nach außen hin abdichtbaren Prüfraum zur Aufnahme eines Prüflings ausbildet, und eine Betauungseinrichtung zum Betauen des Prüflings innerhalb des Prüfraums auf, wobei die Betauungseinrichtung eine Kühlvorrichtung zum Abkühlen des Prüflings auf einen Temperaturwert, bei dem eine Betauung des Prüflings erfolgt, aufweist, und wobei Mittel zum Zuführen eines Versorgungsklimas mit gegenüber dem Prüfraum erhöhter Luftfeuchtigkeit und/oder Temperatur in den Prüfraum vorgesehen sind.

Unter hermetischer Abdichtung ist im Sinne der Erfindung eine Abdichtung nach Art eines bekannten Klimaschrankes oder einer Klimakammer zu verstehen, d.h. es handelt sich um eine quasi luft- und wasserdichte Abdichtung unter Berücksichtigung des Druckausgleichs.

Infolge der bei der erfindungsgemäßen Vorrichtung realisierbaren aktiven Abkühlung des Prüflings auf einen Temperaturwert, bei dem eine Betauung des Prüflings erfolgt, ist die Ausbildung einer Betauungsschicht auf dem Prüfling wesentlich kontrollierter möglich, so daß auch die Reproduzierbarkeit der Betauung signifikant erhöht wird. Hierdurch wird insbesondere gewährleistet, daß bei einer auf Basis der so herbeigeführten Betauung des Prüflings durchgeführten Untersuchung beispielsweise der elektronischen Eigenschaften des Prüflings die Funktionskontrolle sowie die Einleitung geeigneter Vorbeugungsmaßnahmen zwecks Sicherstellung der Funktionsfähigkeit des Prüflings unter Betauungsbedingungen wesentlich zuverlässiger erfolgen kann.

Gemäß einer bevorzugten Ausführungsform weist die Vorrichtung einen Klimabehälter, welcher einen von dem Prüfraum separaten Klimaraum ausbildet, Mittel zum Aufrechterhalten definierter Temperatur- und Feuchtigkeitswerte innerhalb des Klimaraums, und eine Kopplungseinrichtung auf, welche zwischen einer ersten Einstellung, in der der Prüfraum von dem Klimaraum getrennt ist, und einer zweiten Einstellung, in der in dem Klimaraum befindliche Luft in den Prüfraum einströmen kann, umschaltbar ist und beispielsweise als elektronisch gesteuertes Ventil ausgebildet sein kann.

Dadurch, daß zusätzlich zu dem Prüfraum ein separater Klimaraum, Mittel zum Aufrechterhalten definierter Temperatur- und Feuchtigkeitswerte innerhalb des Klimaraums sowie eine den Klimaraum an den Prüfraum selektiv ankoppelnde Kopplungseinrichtung vorgesehen sind, wird eine weitere wesentliche Verbesserung der Reproduzierbarkeit des Betauungsvorganges erreicht, da das im Klimaraum problemlos konstant zu haltende Klima (Luftfeuchtigkeit und Temperatur) zu einem beliebigen Zeitpunkt reproduzierbar dem Prüfraum mittels Betätigung der Kopplungseinrichtung zugeführt werden kann. Der Klimaraum stellt hierbei gewissermaßen ein Versorgungsklima für den Prüfling bereit, welches dem Prüfraum in vergleichsweise sehr kurzer Zeit durch einfaches Umschalten der Kopplungseinrichtung zugeführt werden kann. In meßtechnischer Hinsicht kann die Auswertung des Betauungsvorgangs am Prüfling auf die Größe der Betauung reduziert werden, da keine schrittweise Erhöhung der Temperatur in der Umgebung des Prüflings mehr erforderlich ist. Auf diese Weise wird zum einen der meßtechnische Aufwand verringert und zum anderen kann die Genauigkeit bei der Erzeugung und Überwachung der Betauungsbedingungen signifikant erhöht werden.

Je nach Abmessungen und Art des Prüflings kann die Kopplungseinrichtung auch als pneumatisch betätigbare Verriegelungstür oder -klappe oder als handbetätigbare Verschlußtür oder -klappe oder in anderer geeigneter Weise ausgebildet sein. Insbesondere kann der Prüfbehälter derart dimensioniert sein, daß als Prüfling ein Kraftfahrzeug innerhalb des Prüfraums angeordnet werden kann.

Der Prüfbehälter ist bevorzugt innerhalb des von dem Klimabehälter ausgebildeten Klimaraums angeordnet. Die_ Kühlvorrichtung weist beispielsweise wenigstens ein Peltierelement auf.

Bevorzugte Werte für den innerhalb des Klimaraums aufrechterhaltenen Temperaturwert liegen im Bereich zwischen 10°C wnd 100°C. Bevorzugte Werte für den innerhalb des Klimaraums aufrechterhaltenen Luftfeuchtigkeitswert liegen im Bereich 50% und 99%, bevorzugt zwischen 90% und 95%.

Gemäß einer bevorzugten Ausführungsform ist ferner eine Trocknungseinrichtung vorgesehen, mittels derer der im Prüfraum angeordnete Prüfling aus einem Betauüngszustand in einen getrockneten Zustand überführbar ist. Die Trocknungseinrichtung kann beispielsweise einen Adsorptionstrockner oder einen Kältetrockner aufweisen oder es können zum Trocknen andere bekannte Mittel (Silika-Gel oder dergleichen) eingesetzt werden. Auf diese Weise kann der Prüfling mittels aktiver Trocknung wieder in den Ausgangszustand gebracht werden, so daß ein neuer Betauungsvorgang und ein neuer Meßzyklus eingeleitet werden kann.

Gemäß einer bevorzugten Ausführungsform ist ferner eine Steuereinheit vorgesehen, mittels derer die Betauungseinrichtung und die Trocknungseinrichtung derart ansteuerbar sind, daß eine Mehrzahl aufeinanderfolgender Zyklen mit jeweils einem Betauungs- und einem darauf folgenden Trocknungsvorgang des Prüflings durchführbar ist.

Bei dieser Weise wird besonders vorteilhaft von der hohen Reproduzierbarkeit des Betriebs der erfindungsgemäßen Vorrichtung Gebrauch gemacht, wobei infolge der Mehrzahl von Meßzyklen die Genauigkeit von unter den Betauungsbedingungen durchgeführten Untersuchungen noch weiter gesteigert werden kann.

Vorzugsweise ist der Prüfbehälter mit einer Meßvorrichtung zur In-Situ-Messung von mechanischen und/oder elektronischen Eigenschaften des Prüflings versehen.

Gemäß einer bevorzugten Ausführungsform ist ferner ein Betauungssensor, insbesondere ein kapazitiver oder ein faseroptischer Sensor, zur Detektion einer Betauung des Prüflings durch Liefern eines von der Betauung des Prüflings abhängigen Ausgangssignals vorgesehen. An den Betauungssensor sind bevorzugt Kompensationsmittel derart gekoppelt, daß ein vom Betauungssensor in dessen trockenem Zustand geliefertes Hintergrundsignal meßbar ist und das gemessene Hintergrundsignal bei der Auswertung des Sensorsignals kompensierbar ist, um auf diese Weise eine höhere Nachweisempfindlichkeit der Betauung zu erreichen.

Ein Verfahren zum Betauen eines Prüflings weist folgende Schritte auf: Positionieren des Prüflings innerhalb eines hermetisch nach außen hin abschließbaren, von einem Prüfbehälter ausgebildeten Prüfraums, Abkühlen des Prüflings mittels einer Kühleinrichtung auf einen Temperaturwert, bei dem eine Betauung des Prüflings erfolgt, wobei nach dem Abkühlen des Prüflings Luft mit gegenüber dem Prüfraum erhöhter Luftfeuchtigkeit und/oder Temperatur in den Prüfraum eingeleitet wird.

Das Abkühlen des Prüflings erfolgt auf eine Temperatur unterhalb der Taupunkttemperatur. Bevorzugt wird nach dem Abkühlen des Prüflings Luft mit gegenüber dem Prüfraum erhöhter Luftfeuchtigkeit und/oder Temperatur aus einem von dem Prüfraum separaten Klimaraum in den Prüfraum eingeleitet.

Innerhalb des Klimaraums wird bevorzugt ein Temperaturwert im Bereich zwischen 10°C und 100°C und ein Luftfeuchtigkeitswert bevorzugt zwischen 50% und 99%, weiter bevorzugt zwischen 90% und 95%, aufrechterhalten.

Ferner wird der Prüfling bevorzugt nach erfolgter Betauung mittels Aufheizen des Prüflings und/oder Zuführen von trockenerer Luft in den Prüfraum wieder getrocknet.

Gemäß einer bevorzugten Ausführungsform wird eine Mehrzahl aufeinanderfolgender Zyklen mit jeweils einem Betauungs- und einem darauf folgenden Trocknungsvorgang des Prüflings durchgeführt.

Die Erfindung wird nachstehend anhand von in den beigefügten Abbildungen dargestellten Ausführungsbeispielen näher erläutert.

Es zeigen:

Fig. 1 eine schematische Perspektivskizze zur Erläuterung des Prinzips einer Vorrichtung zum Betauen eines Prüflings gemäß einem bevorzugten Ausführungsbeispiel der vorliegenden Erfindung; und

Fig. 2 ein Blockschaltbild einer bevorzugten Ausführungsform einer in der erfindungsgemäßen Vorrichtung aus Fig. 1 verwendbaren Auswertevorrichtung zum Nachweis der Betauung.

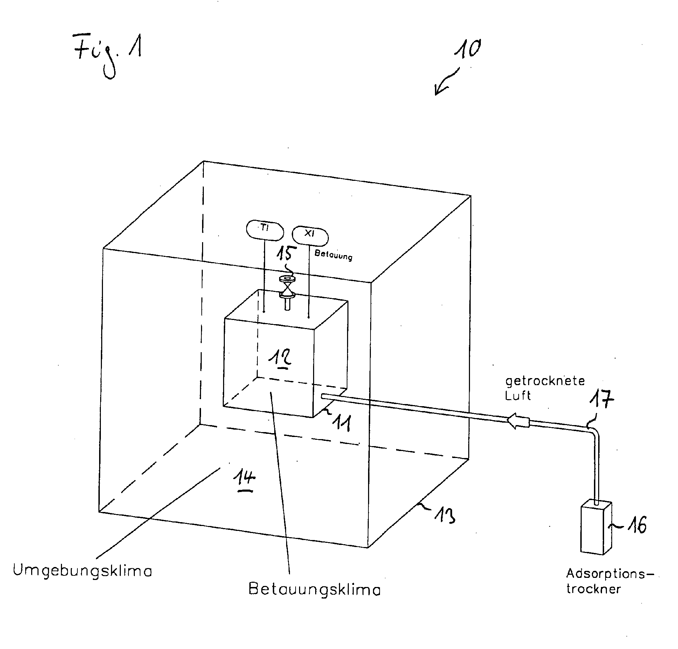

Gemäß Fig. 1 weist eine Vorrichtung 10 zum Betauen eines Prüflings einen Prüfbehälter 11 auf, welcher einen Prüfraum 12 zur Aufnahme eines (nicht dargestellten) Prüflings aufweist. Der Prüfbehälter 11 ist in einem Klimabehälters 13, nämlich innerhalb eines von dem Klimabehälter 13 ausgebildeten Klimaraums 14, angeordnet und dort in beliebiger Weise fixiert. Das Einbringen des Prüflings in den Prüfraum 12 erfolgt in beliebiger Weise, beispielsweise durch eine im Prüfbehälter 11 vorgesehene Öffnung (nicht dargestellt) hindurch, die mittels eines im geschlossenen Zustand hermetisch abdichtenden Verschlußdeckels verschließbar ist.

Sowohl der Prüfbehälter 11 als auch der Klimabehälter 13 sind jeweils für sich nach Art eines bekannten Klimaschrankes in bekannter Weise unter Berücksichtigung eines Druckausgleichs hermetisch abgeschlossen, d.h. quasi luft- und wasserdicht, ausgebildet. Die äußeren Abmessungen von Prüfbehälter 11 und Klimabehälter 13 sind grundsätzlich je nach Einsatzzweck, d.h. insbesondere abhängig von der Art des zu untersuchenden Prüflings, beliebig wählbar. Insbesondere kann der Prüfbehälter 11 für die Untersuchung elektronischer Leiterplatten seitliche Abmessungen von wenigen Zentimetern aufweisen. Andererseits können die seitlichen Abmessungen auch mehrere Meter betragen, wenn beispielsweise dann, wenn ein komplettes Kraftfahrzeug untersucht werden soll, um Aufschluß über den Einfluß der Betauung auf sämtliche wichtige Komponenten des Fahrzeuges im fertig montierten Zustand zu erhalten.

Zur selektiven Kopplung des Prüfraums 12 mit dem Klimaraum 14 ist eine Kopplungseinrichtung 15, gemäß dem dargestellten Ausführungsbeispiel ein elektronisch steuerbares Ventil, an dem Prüfbehälter 11 angebracht, insbesondere in der Außenwand des Prüfbehälters 11 montiert. Die Kopplungseinrichtung 15 ist zwischen einer ersten Einstellung, in der der Prüfraum 12 in bezug auf den Klimaraum 14 hermetisch abgeschlossen ist, und einer zweiten Einstellung, in der in dem Klimaraum 14 befindliche Luft in den Prüfraum 12 einströmen kann, umschaltbar. Zur Umschaltung der Kopplungseinrichtung 15, z.B. des Ventils, kann eine beliebige Ansteuerung vorgesehen sein, mittels welcher die Kopplungseinrichtung 15 insbesondere ferngesteuert von außerhalb des Klimabehälters 13 betätigbar ist.

Die Abmessungen des Klimabehälters 13 sind hierbei bevorzugt in Abhängigkeit von den Abmessungen des Prüfbehälters 11 geeignet zu wählen, so daß das von der im Klimaraum 14 befindlichen Luft bereitgestellte Volumen ausreicht, um ein Einströmen dieser Luft an den Ort des Prüflings innerhalb des Prüfraums 12 zu ermöglichen.

Der Prüfbehälter 11 weist ferner eine Kühlvorrichtung (nicht dargestellt) auf, mittels der der im Prüfraum 12 angeordnete Prüfling auf einen Temperaturwert, bei dem eine Betauung des Prüflings erfolgt, abgekühlt werden kann. Die Kühlvorrichtung kann insbesondere ein oder mehrere Peltierelemente umfassen, wobei vorzugsweise eine Mehrzahl von Peltierelementen an der Innenwand des Prüfbehälters 11 angeordnet, insbesondere über die Innenwand des Prüfbehälters 11 rings um die Position des Prüfling gleichmäßig verteilt sein können.

Der Klimabehälter 13 ist mit einem Klimaaggregat (nicht dargestellt) ausgestattet, mittels dessen innerhalb des Klimaraums 14 konstante Werte für die Temperatur und Luftfeuchtigkeit aufrechterhalten werden können. Gemäß dem Ausführungsbeispiel wird im Klimaraum 14 eine Temperatur von 30°C ($\pm$ 0,1°C) und eine Luftfeuchtigkeit von 95% ($\pm$ 1%) konstant gehalten.

Des weiteren ist eine Trocknungseinrichtung 16, gemäß dem Ausführungsbeispiel in Form eines außerhalb des Klimabehälters 13 angeordneten Adsorptionstrockners, vorgesehen und an den Prüfraum 12 mittels einer durch den Klimabehälter 13 hindurchgeführten Luftzufuhrleitung 17 angeschlossen. Außerdem ist vorzugsweise eine Steuereinrichtung (nicht dargestellt) zum Ansteuern der Kühleinrichtung des Prüfbehälters 11 sowie der Trocknungseinrichtung 16 vorgesehen, so daß die Kopplung/Entkopplung der Behälter 11, 13 sowie Zufuhr trockener Luft in den Prüfbehälter 11 gesteuert werden kann.

Im Betrieb der erfindungsgemäßen Vorrichtung 10 befindet sich zunächst die Kopplungseinrichtung 15 in der ersten Einstellung, in welcher der Prüfraum 12 in bezug auf den Klimaraum 14 hermetisch abgeschlossen ist. Während der Prüfling im Prüfraum sich im trockenen Zustand und bei einer Ausgangstemperatur von beispielsweise 25°C befindet, wird die Luft im Klimaraum 14 mittels des Klimaaggregates bei einer Temperatur von beispielsweise 30°C und einer Luftfeuchtigkeit von 95% konstant gehalten.

Daraufhin wird der in dem Prüfraum 12 angeordnete Prüfling mittels der Kühleinrichtung (z.B. der Peltierelemente) um eine geeignete Temperaturdifferenz bis unterhalb der Taupunkttemperatur heruntergekühlt, wobei die Temperatur am Ort des Prüflings beispielsweise mittels eines Pt-100 Meßwiderstandes oder einer anderen bekannten Temperaturmeßvorrichtung überwacht wird. Nach Herabkühlen des Prüflings wird die Kopplungseinrichtung 15, z.B. das Ventil, in die zweite Einstellung umgeschaltet, so daß die in dem Klimaraum 14 befindliche, relativ feuchte und warme Luft in den Prüfraum 12 einströmen kann. Infolgedessen tritt an dem Prüfling eine Betauung ein, was je nach Anwendung visuell oder auch elektronisch nachgewiesen werden kann, wie weiter unten anhand einer bevorzugten Ausführungsform noch näher erläutert wird.

Je nach Anwendungszweck können die Eigenschaften des Prüflings nun im betauten Zustand in geeigneter Weise untersucht werden. Insbesondere können etwa elektrochemische Migrationseffekte oder Veränderungen der elektronischen Eigenschaften des Prüflings im betauten Zustand mittels geeigneter bekannter Meßvorrichtungen detektiert werden. Ferner können die betreffenden Eigenschaften auch bei fortgesetzter Betauung, d.h. während der Vergrößerung der Dicke des Betauungsfilms an der Oberfläche des Prüflings, gemessen werden.

Anschließend wird zur Vorbereitung eines weiteren Meßzyklus das die Kopplungseinrichtung 15 bildende Ventil wieder in die erste, geschlossene Einstellung umgeschaltet und der Prüfling mittels Zufuhr trockener Luft getrocknet, welche aus dem Adsorptionstrockner 16 über die Zufuhrleitung 17 in den Prüfraum 12 eingeführt wird. Die Abfuhr der hierbei aus dem Prüfraum 12 entweichenden feuchten Luft kann über eine entsprechende separate Abfuhrleitung (nicht dargestellt) oder auch über die Zufuhrleitung 17 erfolgen. Außerdem wird der Prüfling beispielsweise mittels Abschaltung der Kühlvorrichtung und/oder mittels einer zusätzlichen Heizeinrichtung vorzugsweise auf seine Ausgangstemperatur aufgewärmt, so daß er sich wiederum im Ausgangszustand befindet.

Während der obigen Prozeßschritte werden Temperatur und Luftfeuchtigkeit im Klimaraum 14 mittels des Klimaaggregates konstant (d.h. gemäß dem Ausführungsbeispiel bei 30°C bzw. 95%) gehalten.

Bevorzugterweise werden die obigen Schritte des Abkühlens des Prüflings im Prüfraum 12, Einleiten der Luft aus dem Klimaraum 14 in den Prüfraum 12 und Trocknen des Prüflings, über eine Mehrzahl von Meßzyklen wiederholt, indem die Kühleinrichtung des Prüfbehälters 11 sowie die Trocknungseinrichtung 16 mittels der Steuereinheit entsprechend angesteuert werden, so daß die Untersuchung des Prüflings bei jeweils reproduzierten Betauungsbedingungen beliebig oft wiederholt werden kann.

Alternativ zu dem in Fig. 1 dargestellten Ausführungsbeispiel kann der Prüfbehälter 11 auch außerhalb des Klimabehälters 13 angeordnet und mit diesem über eine Verbindungsleitung und eine entsprechend ausgebildete Kopplungseinrichtung, z.B. ein Ventil, koppelbar sein. Ferner kann je nach Einsatzzweck der Klimabehälter auch ganz entfallen, da bereits durch das erfindungsgemäße, aktive Herabkühlen des Prüflings eine Betauung des Prüflings bewirkt werden kann.

Gemäß einer weiteren alternativen Ausführungsform kann auch ein zusätzlicher Unterdruck innerhalb des Prüfraums 12 mittels einer an diesen angeschlossenen Pumpe (nicht dargestellt) erzeugt werden. Auf diese Weise kann der Effekt der Abkühlung des Prüflings mit dem Effekt des Unterdrucks kombiniert werden, so daß die zur Betauung notwendige, zu durchschreitende Temperaturdifferenz verringert ist und damit auch etwaige Meßfehler weiter reduziert werden können.

Als Prüfling kann ferner auch ein vollständig in Bezug auf den Prüfraum 12 hermetisch dicht eingekapselter Prüfling untersucht werden. Hierbei kann es sich beispielsweise um eine hermetisch dicht gekapselte Elektronik oder um einen hermetisch dicht gekapselten Scheinwerfer handeln.

In diesem Falle wird vorzugsweise der oben beschriebene Abkühlvorgang des Prüflings über eine wesentlich größere Temperaturdifferenz von beispielsweise $\Delta T = (80-120)°C$ durchgeführt, so daß ein Unterdruck innerhalb der Einkapselung relativ zum Prüfraum 12 erzeugt wird. Der Unterdruck bewirkt in diesem Falle die Ausbildung einer Betauungsschicht auf dem Prüfling innerhalb der Einkapselung. Die entstandene Betauung sorgt dafür, daß in das hermetisch abgedichtete Gehäuse Feuchtigkeit eindringt.

Wie oben bereits ausgeführt, erfolgt der Nachweis der Betauung des Prüflings vorzugsweise elektronisch mittels eines geeigneten Betauungssensors, welcher ein von der Betauung des Prüflings abhängiges Ausgangssignal liefert. Als Betauungssensor kann beispielsweise ein kapazitiver oder ein faseroptischer Sensor verwendet werden, der jeweils ein bei Betauung des Sensors veränderliches Ausgangssignal liefert.

Bei einem kapazitiven Betauungssensor beruht das Meßprinzip darauf, daß sich bei Einsetzen der Betauung infolge des auf einem Streufeldkondensator auftretenden Feuchtigkeitsniederschlages die Dielektrizitätskonstante $\varepsilon_r$ des Streufeldkondensators und damit seine Kapazität $C = \varepsilon_0 * \varepsilon_r * C_0$ ändert.

Demgegenüber weist ein geeigneter faseroptischer Betauungssensor eine Lichtsendeeinheit und eine Lichtempfängereinheit auf, welche über einen Sensorabschnitt des Betauungssensors derart gekoppelt sind, daß das von einer Feuchtigkeitskondensation auf dem Sensorabschnitt anhängige Sensorsignal durch Änderung des Lichttransmissionskoeffizienten der Anordnung bestimmbar ist.

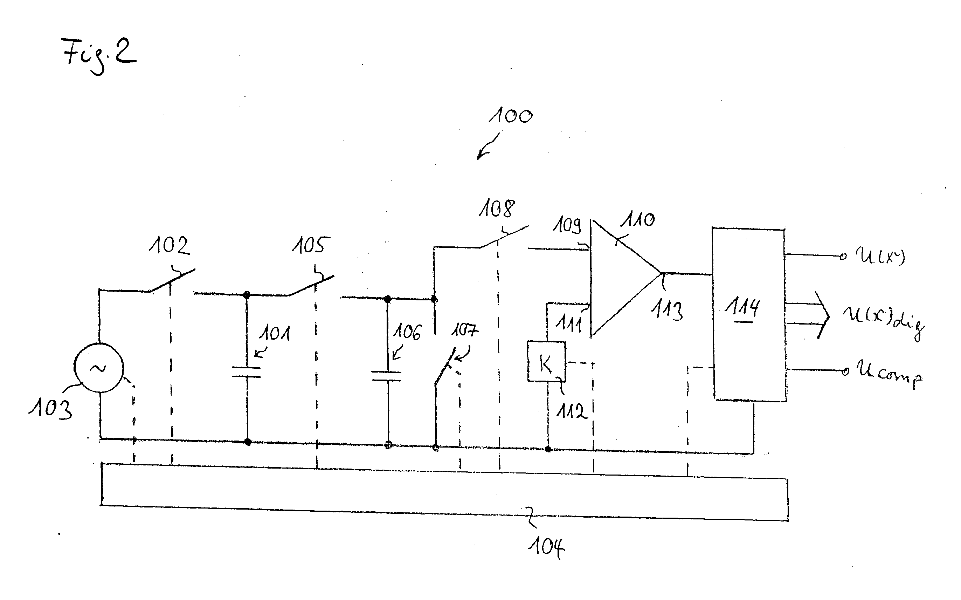

Ein bevorzugtes Ausführungsbeispiel eines kapazitiven Betauungssensors mit der dazugehörigen Auswerteschaltung ist in Fig. 2 dargestellt.

Der Betauungssensor gemäß Fig. 2 ist mit einer speziellen Auswerteschaltung versehen, mittels der die aus dem nachzuweisenden Kondensationsvorgang resultierende Änderung des Ausgangssignals des Sensorelements mit hoher Empfindlichkeit nachgewiesen werden kann, indem jegliche Kapazität der Anordnung, die nicht unmittelbar durch den nachzuweisenden Kondensationsvorgang hervorgerufen wird, kompensiert wird. Dadurch, daß eine Kompensation der von Vorrichtung bzw. Meßumgebung verursachten Störgröße durch gezielte Messung des Ausgangssignals im kondensationsfreien Zustand erfolgt, kann die Betauung im wesentlichen störgrößenunabhängig bestimmt werden.

Der Betauungssensor ist gemäß Fig. 2 als Streufeldkondensator 101 ausgebildet, wobei ein erster Anschluß des Streufeldkondensators 101 über einen ersten Schalter 102 mit einer Wechselspannungsquelle 103 und ein zweiter Anschluß des Streufeldkondensators 101 direkt mit der Wechselspannungsquelle 103 verbunden ist. Der Schalter 102 ist ebenso wie die weiteren im folgenden beschriebenen Schalter vorzugsweise als elektronischer Schalter ausgeführt. Der erste Schalter 102 und die Wechselspannungsquelle 103 werden über eine Ablaufsteuereinheit 104 angesteuert.

Parallel zu dem Streufeldkondensator 101, und von diesem über einen ebenfalls durch die Ablaufsteuereinheit 104 angesteuerten zweiten Schalter 105 trennbar, ist ein Speicherkondensator 106 geschaltet, wobei der erste Anschluß des Streufeldkondensators 101 über den zweiten Schalter 105 mit einem ersten Anschluß des Speicherkondensators 106 verbunden und der zweite Anschluß des Streufeldkondensators 101 direkt mit dem zweiten Anschluß des Speicherkondensators 106 verbunden ist. Ein dem Speicherkondensator 106 parallel geschalteter dritter Schalter 107 dient (in seiner geschlossenen Stellung) zum Kurzschließen des Speicherkondensators 106 und wird durch die Ablaufsteuereinheit 104 angesteuert. Die Kapazität des Speicherkondensators 106 sollte vorzugsweise groß gewählt sein, d.h. ihr Wert sollte wesentlich größer als die durch Kondensationsvorgänge hervorgerufenen Kapazitätsänderungen des Streufeldkondensators 101 sein.

Der erste Anschluß des Speicherkondensators 106 ist über einen ebenfalls durch die Ablaufsteuereinheit 104 angesteuerten vierten Schalter 108 mit einem ersten Eingang 109 eines Summierverstärkers 110 verbunden. Mit einem zweiten Eingang 111 des Summierverstärkers 110 ist ein erster Anschluß eines Kompensationsnetzwerks 112 verbunden, welches von der Ablaufsteuereinheit 104 angesteuert wird. Das Kompensationsnetzwerk 112 kann beispielsweise einen Speicherkondensator und eine steuerbare Spannungsquelle (jeweils nicht dargestellt) umfassen, wobei ein erster Anschluß des Speicherkondensators mit dem zweiten Eingang 111 des Summierverstärkers 110 verbunden ist und wobei der zweite Anschluß des Speicherkondensators mit der über die Ablaufsteuereinheit 104 angesteuerten steuerbaren Spannungsquelle verbunden ist, so daß durch den Speicherkondensator - gemäß Ansteuerung der steuerbaren Spannungsquelle durch die Ansteuereinheit 104 - eine von der Ansteuereinheit 104 eingestellte Ladung an den zweiten Eingang 111 des Summierverstärkers 110 geliefert wird.

Der Ausgang 113 des Summierverstärkers 110 wird einer ebenfalls durch die Ablaufsteuereinheit 104 angesteuerten Signalverarbeitungseinheit 114 zugeführt, welche gemäß dem Ausführungsbeispiel einen Analog-Digital-Wandler und einen Komparator (beides nicht dargestellt) aufweist, so daß mittels der Signalverarbeitungseinheit 114 zusätzlich zu einem analogen Ausgangsspannungssignal $U(x)$ ein digitales Ausgangssignal $U(x)_{dig}$ sowie ein Komparatorsignal $U_{comp}$ erzeugbar ist, wie im folgenden näher erläutert wird.

Der nachfolgend erläuterte Meßbetrieb des Betauungssensors beginnt in einem Zustand, in dem der kapazitive Sensor bereits im Prüfraum, insbesondere am Prüfling angeordnet und damit insbesondere den spezifischen Bedingungen der Meßumgebung ausgesetzt, jedoch noch frei von jeglicher Betauung ist.

In diesem Zustand wird zunächst das Sensorsignal des kapazitiven Sensors, d.h. die Kapazität des Streufeldkondensators 101 in dessen kondensationsfreiem Zustand, bestimmt und an das Kompensationsnetzwerk 112 übertragen. Diese Kapazität wird im folgenden als Grundkapazität $C_0$ des Streufeldkondensators 101 bezeichnet und ist nicht nur vom jeweiligen Aufbau des Streufeldkondensators 101, sondern auch von dessen Umgebung am jeweiligen Meßort, d.h. insbesondere dem Einfluß vorhandener langer Zuleitungen (Anschlußkabel etc) sowie anderer der o.g. Faktoren abhängig. Im Grundzustand befindet sich der zweite Schalter 107 in der geschlossenen Position, so daß der kurzgeschlossene Speicherkondensator 106 vollständig entladen ist. Die übrigen Schalter 102, .105 und 108 befinden sich in der geöffneten Position. Die Messung der Grundkapazität $C_0$ des Streufeldkondensators 101 erfolgt vorzugsweise dadurch, daß die Spannungsquelle 103 durch kurzzeitiges Schließen des Schalters 102 bei Erreichen eines definierten Spannungswertes der Wechselspannungsquelle 103, insbesondere z.B. bei Erreichen deren Spannungsmaximums $U_{max}$, mit dem Streufeldkondensator 101 verbunden wird. Infolgedessen wird der Streufeldkondensator 101 auf einen Ladungswert $Q_0$ aufgeladen, der dem Produkt aus seiner Grundkapazität $C_0$ und dem angelegten Spannungswert $U_{max}$ entspricht, woraufhin der Ladungswert $Q_0$ an das Kompensationsnetzwerk 112 übertragen wird.

Zur Detektion eines Kondensationsvorganges wird wiederum durch kurzzeitiges Schließen des ersten Schalters 102, vorzugsweise bei Erreichen des Spannungsmaximums $U_{max}$ der Wechselspannungsquelle 103 gemäß Steuerung durch die Ablaufsteuereinheit 104, bei geöffnetem zweiten Schalter 105 sowie geöffnetem dritten Schalter 107 eine Spannung $U_{max}$ über die Wechselspannungsquelle 103 an den Streufeldkondensator 101 angelegt. Infolgedessen wird der Streufeldkondensator 101 auf einen Lädungswert $Q(x)$ aufgeladen, der dem Produkt aus seiner Kapazität $C(x)$ und dem angelegten Spannungswert $U_{max}$ entspricht.

$$Q(x) = C(x) * U_{max}. \qquad (1)$$

Da sich bei dem Kondensationsvorgang die Dielektrizitätskonstante $\varepsilon_r$ im Streufeld des Streufeldkondensators 101 infolge der zusätzlich vorhandenen Flüssigkeitsmöleküle gegenüber dem kondensationsfreien Zustand ändert, gilt für die Kapazität des Streufeldkondensators 101 die Beziehung

$$C(x) = C_0 + \Delta C(x) \qquad (2)$$

wobei $C_0$ die oben beschriebene Grundkapazität und $\Delta C(x)$ die durch den Einfluß des Kondensationsvorganges verursachte Kapazitätsänderung des Streufeldkondensators 101 bezeichnet.

Anschließend wird durch Öffnen des ersten Schalters 102 und Schließen des zweiten Schalters 105 mittels der Ablaufsteuerung 104 die auf dem Streufeldkondensator 101 angesammelte Ladung auf den Speicherkondensator 106 übertragen, d.h. umgespeichert. Daraufhin wird der zweite Schalter 105 wieder geöffnet und der erste Schalter 102 wieder (wie oben beschrieben) im Spannungsmaximum $U_{max}$ der Wechselspannungsquelle 103 geschlossen, um den Streufeldkondensator 101 erneut aufzuladen, woraufhin diese Ladung erneut durch Öffnen des Schalters 102 und Schließen des Schalters 105 von dem Streufeldkondensator 101 auf den Speicherkondensator 106 übertragen bzw. umgespeichert wird.

Durch mehrfaches (im folgenden n-maliges) Wiederholen der Lade-/Entladezyklen des Streufeldkondensators 101 wird die auf dem Speicherkondensator 106 befindliche Ladung $Q_s$ auf einen Wert

$$Q_s = n * Q(x) \qquad (3)$$

erhöht, wobei Q(x) die durch einmaliges Aufladen des Streufeldkondensators 101 auf diesen aufgebrachte Ladung bezeichnet (hierbei gilt jeweils Q(x) = C(x) * $U_{max}$).

Je größer der Wert n gewählt wird, um so größer ist die auf dem Speicherkondensator angesammelte Ladung $Q_s$. Da dieses kumulative Speichern der von dem Streufeldkondensator 101 abfließenden Ladung einer Integration über mehrere Lade/Entladezyklen gleichkommt, wird - wie im folgenden beschrieben - hierdurch eine Mittelwertbildung hinsichtlich der gemessenen, durch den Kondensationsvorgang hervorgerufenen Kapazitätsänderung erreicht, wodurch die Empfindlichkeit der Anordnung weiter erhöht wird.

Nach Erreichen der vorbestimmbaren Anzahl n von Lade/Entladezyklen des Streufeldkondensators 101 wird die auf dem Speicherkondensator 106 angesammelte Ladungsmenge $Q_s$ = n * Q(x) gemäß Steuerung durch die Steuerungseinheit 104 durch Schließen des vierten Schalters 108 dem ersten Eingang 109 des Summierverstärkers 110 zugeführt, wobei es in ein entsprechendes, der Ladungsmenge $Q_s$ proportionales Spannungsoder Stromsignal umgewandelt wird.

Außerdem wird von dem Kompensationsnetzwerk 112 dem zweiten Eingang 111 des Summierverstärkers 110 ein durch das steuerbare Kompensationsnetzwerk 112 entsprechend eingestelltes, der Ladung Q' = n * $Q_0$ (mit $Q_0$ = $C_0$ * $U_{max}$) proportionales Spannungssignal U' oder, je nach Ausgestaltung des Kompensationsnetzwerks 112, ein dieser Ladung Q' proportionales Stromsignal I' zugeführt.

Der Summierverstärker 110 subtrahiert die an den Eingängen 109 und 111 anliegenden elektrischen Größen (entsprechend den Ladungsmengen $Q_s$ bzw. n*$Q_0$) voneinander und liefert an seinem Ausgang 113 ein entsprechendes Differenzsignal U(x), welches der Signalverarbeitungseinheit 114 zugeführt wird.

Die Signalverarbeitungseinheit 114 erzeugt aus dem Differenzsignal U(x) mittels des Analog-Digital-Wandlers ein digitales Ausgangssignal U(x)$_{dig}$ sowie mittels des Komparators durch Vergleich mit einem vorgegebenen Schwellenwert ein Komparatorsignal $U_{comp}$, welches als Indikatorsignal für den Kondensationsvorgang dient und beispielsweise zur entsprechenden Ansteuerung einer Klimaanlage verwendet werden kann.

Alternativ kann die Auswerteschaltung auch so ausgestaltet sein, daß - statt einer Integration über n Lade-Entladevorgänge vor Übermittlung der erhaltenen Signale an den Summierverstärker 113 - eine Kompensation durch Subtraktion des der Grundkapazität entsprechenden Signals in dem Summierverstärker 110 nach jedem einzelnen Lade/Entladezyklus des Streufeldkondensators 101 vorgenommen wird. Eine Aufintegration über mehrere so erhaltene Differenzsignale kann dann beispielsweise direkt in der Signalverarbeitungseinheit 115 erfolgen.

Infolge der Kompensation der Grundkapazität des Streufeldkondensators 101 wird auch eine relativ zur Grundkapazität $C_0$ geringe Kapazitätsänderung des Sensorelements infolge eines Kondensationsvorganges mit sehr hoher Empfindlichkeit nachgewiesen, wobei jegliche zusätzlich vorhandenen Störgrößen am Meßort kompensiert werden.

Außerdem wird durch die oben beschriebene Aufintegration über mehrere Meßzyklen eine Mittelwertbildung über eine Mehrzahl von einzelnen Meßwerten und damit eine weitere Erhöhung der Empfindlichkeit erreicht.

Der oben beschriebene Betauungssensor bzw. die zugehörige Auswertevorrichtung sind zum Nachweis der Betauung in solchen Fällen besonders geeignet, in denen eine Betauung mit sehr hoher Empfindlichkeit und insbesondere bereits dann nachgewiesen werden soll, wenn sie visuell noch nicht erkennbar ist. Grundsätzlich kann die erfindungsgemäße Vorrichtung jedoch auch eine andere geeignete Nachweisvorrichtung zum Nachweis der Betauung aufweisen oder es kann auf eine solche Nachweisvorrichtung je nach Anwendung auch ganz verzichtet werden, falls eine visuelle Kontrolle der Betauung etwa durch ein im Prüfbehälter sowie gegebenenfalls im Klimabehälter vorgesehenes, hermetisch abgedichtetes Sichtfenster ausreichend ist.

Zusammenfassend ist bei der erfindungsgemäßen Vorrichtung bzw. dem Verfahren die Ausbildung einer Betauungsschicht auf dem Prüfling wesentlich kontrollierter und reproduzierbarer möglich, so daß auch die auf Basis der Betauung des Prüflings durchgeführten Untersuchungen der beispielsweise elektronischen Eigenschaften des Prüflings, die Funktionskontrolle sowie die Einleitung geeigneter Vorbeugungsmaßnahmen zwecks Sicherstellung der Funktionsfähigkeit des Prüflings unter Betauungsbedingungen wesentlich zuverlässiger erfolgen kann.

Eine weitere wesentliche Verbesserung der Reproduzierbarkeit des Betauungsvorganges wird dadurch erreicht, da das konstante Klima (Luftfeuchtigkeit und Temperatur) aus dem separaten Klimaraum reproduzierbar dem Prüfraum zugeführt werden kann, so daß der Klimaraum ein Versorgungsklima für den Prüfling bereitstellt, welches dem Prüfraum in vergleichsweise sehr kurzer Zeit zugeführt werden kann. Die Auswertung des Betauungsvorgangs wird auf die Größe der Betauung reduziert, der meßtechnische Aufwand wird verringert und die Genauigkeit bei der Erzeugung und Überwachung der Betauungsbedingungen wird signifikant erhöht.

Bezugszeichenliste

| | |
|---|---|
| 10 | Betauungsvorrichtung |
| 11 | Prüfbehälter |
| 12 | Prüfraum |
| 13 | Klimabehälter |
| 14 | Klimaraum |
| 15 | Kopplungsvorrichtung |
| 16 | Zufuhrleitung |
| 17 | Adsorptionstrockner |
| | |
| 100 | Blockschaltbild |
| 101 | Streufeldkondensator |
| 102 | erster Schalter |
| 103 | Wechselspannungsquelle |
| 104 | Ablaufsteuereinheit |
| 105 | zweiter Schalter |
| 106 | Speicherkondensator |
| 107 | dritter Schalter |
| 108 | vierter Schalter |
| 109 | erster Eingang / Summierverstärker |
| 110 | Summierverstärker |
| 111 | zweiter Eingang / Summierverstärker |
| 112 | Kompensationsnetzwerk |
| 113 | Ausgang / Summierverstärker |
| 114 | Signalverarbeitungseinheit |

**Patentansprüche**

1. Vorrichtung zum Betauen eines Prüflings, mit

   - einem Prüfbehälter (11), welcher einen hermetisch nach außen hin abdichtbaren Prüfraum (12) zur Aufnahme eines Prüflings ausbildet;
   - einer Betauungseinrichtung zum Betauen des Prüflings innerhalb des Prüfraums (12), wobei die Betauungseinrichtung eine Kühlvorrichtung zum Abkühlen des Prüflings auf einen Temperaturwert, bei dem eine Betauung des Prüflings erfolgt, aufweist; und
   - Mitteln zum Zuführen eines Versorgungsklimas mit gegenüber dem Prüfraum (12) erhöhter

   Luftfeuchtigkeit und/oder Temperatur in den Prüfraum (12).

2. Vorrichtung nach Anspruch 1, wobei die Mittel zum Zuführen eines Versorgungsklimas in den Prüfraum (12) aufweisen:

   - einen Klimabehälter (13), welcher einen von dem Prüfraum (12) separaten Klimaraum (14) ausbildet
   - Mittel zum Aufrechterhalten definierter Temperaturund Feuchtigkeitswerte innerhalb des Klimaraums (14); und
   - eine Kopplungseinrichtung (15), welche zwischen einer ersten Einstellung, in der der Prüfraum (12) von dem Klimaraum (14) getrennt ist, und einer zweiten Einstellung, in der in dem Klimaraum (14) befindliche Luft in den Prüfraum (12) einströmen kann, umschaltbar ist.

3. Vorrichtung nach Anspruch 2, wobei die Kopplungseinrichtung (15) als elektronisch gesteuertes Ventil ausgebildet ist.

4. Vorrichtung nach Anspruch 2, wobei die Kopplungseinrichtung (15) als vorzugsweise pneumatisch betätigbare Verriegelungstür oder -klappe oder als handbetätigbare Verschlußtür oder -klappe ausgebildet ist.

5. Vorrichtung nach einem der Ansprüche 2 bis 4, wobei der Prüfbehälter (11) innerhalb des von dem Klimabehälter (13) ausgebildeten Klimaraums (14) angeordnet ist.

6. Vorrichtung nach einem der vorhergehenden Ansprüche, wobei die Kühlvorrichtung wenigstens ein Peltierelement aufweist.

7. Vorrichtung nach einem der Ansprüche 2 bis 6, wobei der innerhalb des Klimaraums (14) aufrechterhaltene Temperaturwert im Bereich zwischen 10°C und 100°C liegt, und der innerhalb des Klimaraums (14) aufrechterhaltene Luftfeuchtigkeitswert im Bereich zwischen 50% und 99%, bevorzugt zwischen 90% und 95%, liegt.

8. Vorrichtung nach einem der vorhergehenden Ansprüche, ferner mit einer Trocknungseinrichtung (16), mittels derer der im Prüfraum (12) angeordnete Prüfling aus einem Betauungszustand in einen getrockneten Zustand überführbar ist.

9. Vorrichtung nach Anspruch 8, wobei die Trocknungseinrichtung (16) einen Adsorptionstrockner oder einen Kältetrockner aufweist.

**10.** Vorrichtung nach einem der vorhergehenden Ansprüche, wobei der Prüfbehälter (11) derart dimensioniert ist, daß als Prüfling ein Kraftfahrzeug innerhalb des Prüfraums (12) angeordnet werden kann.

**11.** Vorrichtung nach einem der Ansprüche 8 bis 10, wobei ferner eine Steuereinheit vorgesehen ist, mittels derer die Betauungseinrichtung und die Trocknungseinrichtung (16) derart ansteuerbar sind, daß eine Mehrzahl aufeinanderfolgender Zyklen mit jeweils einem Betauungsund einem darauf folgenden Trocknungsvorgang des Prüflings durchführbar ist.

**12.** Vorrichtung nach einem der vorhergehenden Ansprüche, wobei der Prüfbehälter (11) mit einer Meßvorrichtung zur In-Situ-Messung von mechanischen und/oder elektronischen Eigenschaften des Prüflings versehen ist.

**13.** Vorrichtung nach einem der vorhergehenden Ansprüche, wobei ferner ein Betauungssensor (101) zur Detektion einer Betauung des Prüflings durch Liefern eines von der Betauung des Prüflings abhängigen Ausgangssignals vorgesehen ist.

**14.** Vorrichtung nach Anspruch 13, wobei der Betauungssensor (101) ein kapazitiver oder ein faseroptischer Sensor ist.

**15.** Vorrichtung nach Anspruch 13 oder 14, wobei an den Betauungssensor Kompensationsmittel derart gekoppelt sind, daß ein vom Betauungssensor (101) in dessen trockenem Zustand geliefertes Hintergrundsignal meßbar ist und das gemessene Hintergrundsignal bei der Auswertung des Sensorsignals kompensierbar ist.

**16.** Verfahren zum Betauen eines Prüflings, wobei das Verfahren folgende Schritte aufweist:

- Positionieren des Prüflings innerhalb eines hermetisch nach außen hin abschließbaren, von einem Prüfbehälter (11) ausgebildeten Prüfraums (12); und
- Abkühlen des Prüflings mittels einer Kühleinrichtung auf einen Temperaturwert, bei dem eine Betauung des Prüflings erfolgt;
- wobei nach dem Abkühlen des Prüflings Luft mit gegenüber dem Prüfraum (12) erhöhter Luftfeuchtigkeit und/oder Temperatur in den Prüfraum (12) eingeleitet wird.

**17.** Verfahren nach Anspruch 16, wobei das Einleiten von Luft mit gegenüber dem Prüfraum (12) erhöhter Luftfeuchtigkeit und/oder Temperatur in den Prüfraum (12) aus einem separaten Klimaraum (14) erfolgt.

**18.** Verfahren nach Anspruch 16 oder 17, wobei der Prüfling nach erfolgter Betauung mittels Aufheizen des Prüflings und/oder Zuführen von trockenerer Luft in den Prüfraum (12) wieder getrocknet wird.

**19.** Verfahren nach Anspruch 18, wobei eine Mehrzahl aufeinanderfolgender Zyklen mit jeweils einem Betauungsund einem darauf folgenden Trocknungsvorgang des Prüflings durchgeführt wird.

**20.** Verfahren nach einem der Ansprüche 16 bis 19, wobei beim Abkühlen des Prüflings der Taupunkt unterschritten wird.

**21.** Verfahren nach einem der Ansprüche 17 bis 20, wobei innerhalb des Klimaraums (14) ein Temperaturwert im Bereich zwischen 10°C und 100°C und ein Luftfeuchtigkeitswert zwischen 50% und 99%, bevorzugt zwischen 90% und 95%, aufrechterhalten wird.

Fig. 1

10

TI    XI

15    Betauung

12

11

getrocknete
Luft

17

Umgebungsklima

Betauungsklima

14

13

16

Adsorptionstrockner

Fig. 2